(19) Europäisches Patentamt
European Patent Office
Office européen des brevets

(11) **EP 4 231 558 A1**

(12) **EUROPEAN PATENT APPLICATION**
published in accordance with Art. 153(4) EPC

(43) Date of publication:
**23.08.2023 Bulletin 2023/34**

(21) Application number: **21890645.1**

(22) Date of filing: **05.07.2021**

(51) International Patent Classification (IPC):
**H04L 1/00** (2006.01) **H03M 13/13** (2006.01)

(52) Cooperative Patent Classification (CPC):
**H04L 1/00; H03M 13/13**

(86) International application number:
**PCT/CN2021/104467**

(87) International publication number:
**WO 2022/100114 (19.05.2022 Gazette 2022/20)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **16.11.2020 CN 202011277626**

(71) Applicant: **Huawei Technologies Co., Ltd.
Shenzhen, Guangdong 518129 (CN)**

(72) Inventors:
• **WANG, Xianbin
Shenzhen, Guangdong 518129 (CN)**
• **ZHANG, Huazi
Shenzhen, Guangdong 518129 (CN)**
• **HUANGFU, Yourui
Shenzhen, Guangdong 518129 (CN)**
• **TONG, Jiajie
Shenzhen, Guangdong 518129 (CN)**
• **DAI, Shengchen
Shenzhen, Guangdong 518129 (CN)**
• **LI, Rong
Shenzhen, Guangdong 518129 (CN)**
• **WANG, Jun
Shenzhen, Guangdong 518129 (CN)**

(74) Representative: **Epping - Hermann - Fischer
Patentanwaltsgesellschaft mbH
Schloßschmidstraße 5
80639 München (DE)**

(54) **POLARIZATION CODING METHOD AND APPARATUS**

(57) This application provides a polar encoding method and apparatus. The method includes: obtaining a second sequence L2 based on a first sequence L1 (S510); determining a subchannel number of a third sequence from a subchannel number of the first sequence based on a subchannel number of the second sequence L2 (S520), where the third sequence is a sequence that is obtained by extending the first sequence and the second sequence and that has a length of $2^n*N_0$, and the subchannel number of the third sequence L3 is the subchannel number of the first sequence L1 plus $j*N_0$, where j is greater than or equal to 0 and less than or equal to $2^n-1$; and performing encoding based on the third sequence (S530). Encoding is performed based on a sequence obtained by extending a short sequence. This fully utilizes feature information of the short sequence, improves performance gain of the extended sequence, reduces complexity of sequence extension, and further improves encoding performance and reduces encoding complexity.

500

Obtain a second sequence L2 based on a first sequence L1 — S510

Determine a subchannel number of a third sequence from a subchannel number of the first sequence based on a subchannel number of the second sequence L2 — S520

Perform encoding based on the third sequence — S530

FIG. 5

EP 4 231 558 A1

## Description

This application claims priority to Chinese Patent Application No. 202011277626.9, filed with the China National Intellectual Property Administration on November 16, 2020 and entitled "POLAR ENCODING METHOD AND APPARATUS", which is incorporated herein by reference in its entirety.

## TECHNICAL FIELD

This application relates to the communication field, and more specifically, to a polar encoding method and apparatus.

## BACKGROUND

Three most typical communication scenarios in a 5th generation (5th generation, 5G) communication system include enhanced mobile broadband (enhanced mobile broadband, eMBB), massive machine type communication (massive machine type communication, mMTC), and a scenario and ultra-reliable and low-latency communication (ultra-reliable and low-latency communication, URLLC). Requirements of the communication scenarios pose new challenges to an existing long term evolution (long term evolution, LTE) technology. As a most basic radio access technology, channel encoding is one of important research objects that meet 5G communication requirements.

This application relates to a polar code (polar code). The polar code is a first channel encoding method that can be strictly proved to "reach" a channel capacity. A key problem in polar code construction is to determine an information bit sequence number set. Further research shows that a polar code may be constructed by using a sequence. When the polar code is constructed, the information bit set can be determined by reading only a corresponding sequence.

A sequence length used by an existing polar code is 1024, but cannot be directly applied to longer polar code construction. In addition, optimally constructing a sequence of the polar code can be difficult. To resolve this problem, a feasible practice is to first construct an optimal short sequence (for example, a new radio (NR) sequence with a length of 1K), and then extend the sequence to a required length. Currently, there is a polarization weight (polarization weight, PW) sequence extension method. However, performance of a sequence extended by using this approximation algorithm is poor. In addition, because the extension method involves a floating-point operation, extension complexity is also high.

For the foregoing problem, this application provides a polar encoding method, to perform encoding based on a sequence obtained by extending a short sequence. This can reduce complexity of sequence extension while performance of the extended sequence is improved, and further improve encoding performance and reduce encoding complexity.

## SUMMARY

This application provides a polar encoding method and apparatus, to perform encoding based on a sequence obtained by extending a short sequence. This fully utilizes feature information of the short sequence, improves performance of the extended sequence, reduces complexity of sequence extension, and further improves encoding performance and reduces encoding complexity.

According to a first aspect, a polar encoding method is provided. The method includes: obtaining a second sequence L2 based on a first sequence L1, where the first sequence L1 includes $N_0$ subchannel numbers, the second sequence L2 includes $2^{n}*N_0$ subchannel numbers, and n is an integer greater than or equal to 1; determining a subchannel number of a third sequence from a subchannel number of the first sequence based on a subchannel number of the second sequence L2, where the third sequence is a sequence that is obtained by extending the first sequence and the second sequence and that has a length of $2^{n}*N_0$, and the subchannel number of the third sequence L3 is the subchannel number of the first sequence L1 plus $j*N_0$, where j is greater than or equal to 0 and less than or equal to $2^{n}-1$; and performing encoding based on the third sequence.

It should be understood that, in this embodiment of this application, that a sequence includes $N_0$ subchannel numbers may also be represented as that a length of the sequence is $N_0$. A value of $N_0$ may be, for example, a sequence length 1024 of a currently used polar code, or may be another value. This is not limited in this embodiment of this application.

Encoding is performed based on a sequence obtained by extending a short sequence. This fully utilizes feature information of the short sequence, improves performance of the extended sequence, reduces complexity of sequence extension, and further improves encoding performance and reduces encoding complexity.

With reference to the first aspect, in some implementations of the first aspect, the determining a subchannel number of a third sequence from a subchannel number of the first sequence based on a subchannel number of the second sequence L2 includes: if the subchannel number of the second sequence L2 is greater than $(j*N_0)/2^n$ and less than or equal to $(j+1)*N_0/2^n$, determining the subchannel number of the third sequence L3 as: a $t_j$-th subchannel number of the first sequence L1 plus $j*N_0$, where a value of $t_j$ is a previous value of $t_j$ plus 1, an initial value of $t_j$ is 1, and $t_j$ is greater than or equal to 1 and less than or equal to $N_0$.

It should be understood that, in this embodiment of this application, the $t_j$-th subchannel number selected from the first sequence L1 is selected from the first sequence L1 from front to back. To be specific, the initial value of $t_j$ is 1, and $t_j$ is selected from the first element of the first sequence L1.

With reference to the first aspect, in some implementations of the first aspect, the obtaining a second sequence L2 based on a first sequence L1 includes: determining that the subchannel number of the second sequence is

$$Q\_L1\left(\left\lceil \frac{i}{2^n} \right\rceil\right)$$

, where $\lceil\ \rceil$ indicates rounding up, i indicates a sequence number of the subchannel number, and i is greater than or equal to 1 and less than or equal to $2^n * N_0$.

According to a second aspect, a polar encoding method is provided. The method includes: obtaining X sequences based on a basic sequence, where the basic sequence includes $N_0$ subchannel numbers, each of the X sequences includes $2^n * N_0$ subchannel numbers, X is 1, 2, 3, ..., or $2^n$, and n is an integer greater than or equal to 1; reading $K_1$ first subchannel numbers from the basic sequence from back to front based on an information bit quantity k, where the information bit quantity k is greater than or equal to 1 and less than or equal to $2^n * N_0$, $K_1$ is equal to $K/2^n$, and the information bit quantity k is an information bit quantity of an extended sequence obtained based on the basic sequence and the X sequences; determining, based on the first subchannel number read from the basic sequence, that a quantity of subchannel numbers that is greater than $(j*N_0)/2^n$ and less than or equal to $(j+1)*N_0/2^n$ is $m_j$, where j is greater than or equal to 0 and less than or equal to $2^n-1$, and $m_j$ is greater than or equal to 1 and less than or equal to $N_0$; and reading $m_j$ second subchannel numbers from a $(j+1)^{th}$ sequence from back to front; determining the extended sequence based on the read second subchannel label, and performing encoding based on the extended sequence.

Optionally, in this embodiment of this application, a manner of obtaining the X sequences based on the basic sequence may be: adding $(X-1)*N_0$ to each subchannel number of the basic sequence, where X is 1, 2, 3, ..., or 2n.

Encoding is performed based on a sequence obtained by extending a short sequence. This fully utilizes feature information of the short sequence, improves performance of the extended sequence, reduces complexity of sequence extension, and further improves encoding performance and reduces encoding complexity.

With reference to the second aspect, in some implementations of the second aspect, the method further includes: when the information bit quantity $k \neq K_1 2^n$ n, reading $K-K_1 2^n$ third subchannel numbers from the X sequences.

With reference to the second aspect, in some implementations of the second aspect, the determining the extended sequence based on the read second subchannel numbers includes: determining, taking the information bit quantity k as 1 to M and based on the second subchannel number read when the information bit quantity is k and k-1, that a sequence of the newly added second subchannel number is a $k^{th}$ bit, and repeating the foregoing steps to obtain the extended sequence.

According to a third aspect, a polar encoding method is provided and applied to a polar code. The method includes: obtaining a third sequence, where a length of the third sequence is $2N_0$, the third sequence is indicated by a fourth sequence whose length is $2N_0$ and a fifth sequence whose length is $N_0$, elements of the fourth sequence and the fifth sequence meet at least one of a first condition and a second condition, the first condition is L4(2j-1)=L4(2j), the second condition is $L5(_j)<N_0/2$ and L4(2j)=0, or the second condition is L5(j)>$N_0/2$ and L4(2j)=1, j is an element sequence number, and j is greater than or equal to 1 and less than or equal to N; and performing encoding based on the third sequence.

It should be understood that the third sequence used in the encoding method in this embodiment of this application may be a sequence that directly meets the foregoing static limitation condition, and an $N_0$ sequence including an element less than or equal to $N_0$ or an element greater than $N_0$ extracted from the third sequence meets the foregoing limitation condition. In other words, the third sequence appearing as a whole can meet the foregoing static limitation condition, or if a part of the third sequence meets the foregoing static limitation addition, it can be determined that the third sequence uses the sequence extension method used in the encoding method in this embodiment of this application.

Encoding is performed based on the third sequence with a sequence for indication meeting a preset condition. The third sequence is an extended sequence. The third sequence fully utilizes feature information of the short sequence, improves performance gain of the extended sequence, reduces complexity of sequence extension, and further improves encoding performance and reduces encoding complexity.

With reference to the third aspect, in some implementations of the third aspect, the fourth sequence is as follows: when an $i^{th}$ element of the third sequence is less than or equal to $N_0$, an $i^{th}$ element of the fourth sequence is 0; or when the $i^{th}$ element of the third sequence is greater than $N_0$, the $i^{th}$ element of the fourth sequence is 1, where i is an element sequence number, and i is greater than or equal to 1 and less than or equal to $2N_0$.

With reference to the third aspect, in some implementations of the third aspect, the fifth sequence is a set of elements less than or equal to $N_0$ in an element of the third sequence.

According to a fourth aspect, a polar encoding apparatus is provided. The apparatus includes: an obtaining module, configured to obtain a second sequence L2 based on a first sequence L1, where the first sequence L1 includes $N_0$ subchannel numbers, the second sequence L2 includes $2^n * N_0$ subchannel numbers, and n is an integer greater than or equal to 1; and a processing module, configured to determine a subchannel number of a third sequence from a subchannel number of the first sequence based on a subchannel number of the second sequence L2, where the third sequence is a sequence that is obtained by extending the first sequence and the second sequence and that has a length of $2^n*N_0$, the subchannel number of the third sequence L3 is the subchannel number of the first sequence L1 plus $j*N_0$, where j is greater than or equal to 0 and less than or equal to $2^n-1$, and the processing module is further configured to perform encoding based on the third sequence.

With reference to the fourth aspect, in some implementations of the fourth aspect, the processing module is specifically configured to: if the subchannel number of the second sequence L2 is greater than $(j*N_0)/2^n$ and less than or equal to $(j+1)*N_0/2^n$, determine the subchannel number of the third sequence L3 as: a $t_j^{th}$ subchannel number of the first sequence L1 plus $j*N_0$, where a value of $t_j$ is a previous value of $t_j$ plus 1, an initial value of $t_j$ is 1, and $t_j$ is greater than or equal to 1 and less than or equal to $N_0$.

With reference to the fourth aspect, in some implementations of the fourth aspect, the processing module is specifically configured to determine that the subchannel number of the second sequence is

$$Q\_L1\left(\left\lceil \frac{i}{2^n} \right\rceil\right)$$

, where $\lceil \rceil$ indicates rounding up, i indicates a sequence number of the subchannel number, and i is greater than or equal to 1 and less than or equal to $2^n*N_0$.

According to a fifth aspect, a polar encoding apparatus is provided. The apparatus includes: a second obtaining module, configured to obtain X sequences based on a basic sequence, where the basic sequence includes $N_0$ subchannel numbers, each of the X sequences includes $2^n*N_0$ subchannel numbers, X is 1, 2, 3, ..., or $2^n$, and n is an integer greater than or equal to 1; and a second processing module, configured to read $K_1$ first subchannel numbers from the basic sequence from back to front based on an information bit quantity k, where the information bit quantity k is greater than or equal to 1 and less than or equal to $2^n*N_0$, $K_1$ is equal to $K/2^n$, and the information bit quantity k is an information bit quantity of an extended sequence obtained based on the basic sequence and the X sequences; and the second processing module is further configured to determine, based on the first subchannel number read from the basic sequence, that a quantity of subchannel numbers that is greater than $(j*N_0)/2^n$ and less than or equal to $(j+1)*N_0/2^n$ is $m_j$, where j is greater than or equal to 0 and less than or equal to $2^n-1$, and $m_j$ is greater than or equal to 1 and less than or equal to $N_0$; read $m_j$ second subchannel numbers from a $(j+1)^{th}$ sequence from back to front; determine the extended sequence based on the read second subchannel numbers; and perform encoding based on the extended sequence.

With reference to the fifth aspect, in some implementations of the fifth aspect, the second processing module is further configured to: when the information bit quantity $k \neq K_1 2^n$ n, read $K-K_1 2^n$ third subchannel numbers from the X sequences.

With reference to the fifth aspect, in some implementations of the fifth aspect, the second processing module is specifically configured to: determine, taking the information bit quantity k as 1 to M and based on the second subchannel number read when the information bit quantity is k and k-1, that a sequence of the newly added second subchannel number is a $k^{th}$ bit, and repeat the foregoing steps to obtain the extended sequence.

According to a sixth aspect, a polar encoding apparatus is provided and applied to a polar code. The apparatus includes: a third obtaining module, configured to obtain a third sequence, where a length of the third sequence is $2N_0$, the third sequence is indicated by a fourth sequence whose length is $2N_0$ and a fifth sequence whose length is $N_0$, elements of the fourth sequence and the fifth sequence meet at least one of a first condition or a second condition: the first condition is $L4(2j-1)=L4(2j)$, and the second condition is $L5(j)<N_0/2$ and $L4(2j)=0$, or the second condition is $L5(j)>N_0/2$ and $L4(2j)=1$, j is an element sequence number, and j is greater than or equal to 1 and less than or equal to $N_0$; and the third processing module, configured to perform encoding based on the third sequence.

With reference to the sixth aspect, in some implementations of the sixth aspect, the fourth sequence is as follows: when an $i^{th}$ element of the third sequence is less than or equal to $N_0$, an $i^{th}$ element of the fourth sequence is 0; or when the $i^{th}$ element of the third sequence is greater than $N_0$, the $i^{th}$ element of the fourth sequence is 1, where i is an element sequence number, and i is greater than or equal to 1 and less than or equal to $2N_0$.

With reference to the sixth aspect, in some implementations of the sixth aspect, the fifth sequence is a set of elements less than or equal to $N_0$ in an element of the third sequence.

According to a seventh aspect, a polar encoding apparatus is provided. The polar encoding apparatus has a function of implementing the method according to the foregoing aspects. The function may be implemented by using hardware, or may be implemented by hardware by executing corresponding software. The hardware or the software includes one or more modules corresponding to the function.

According to an eighth aspect, a polar encoding apparatus is provided, including a processor. The processor may be coupled to a memory, and is configured to invoke a computer program from the memory and run the computer program, to perform the method in any one of the foregoing aspects or the possible implementations of the foregoing aspects.

According to a ninth aspect, a polar encoding apparatus is provided, including a processor and a memory. The memory is configured to store a computer program, and the processor is configured to invoke the computer program from the memory and run the computer program, to enable the communication device to perform the method in any one of the foregoing aspects or the possible implementations of the foregoing aspects.

According to a tenth aspect, a polar encoding apparatus (for example, the apparatus may be a chip system) is provided. The apparatus includes a processor, configured to support the communication apparatus in implementing functions in the foregoing aspects. In a possible design, the apparatus further includes a memory. The memory is configured to store program instructions and data that are necessary for the communication apparatus. When the apparatus is a chip system, the chip system may include a chip, or may include a chip and another discrete device.

According to an eleventh aspect, a computer-readable storage medium is provided, and is configured to store a computer program. The computer program includes instructions used to perform the method in any one of the foregoing aspects or the possible implementations of the foregoing aspects.

According to a twelfth aspect, a computer program product is provided, including a computer program. When the computer program is run on a computer device, the computer device is enabled to perform the method in the foregoing aspects.

According to a thirteenth aspect, a chip is provided. The chip includes a logic circuit and an input/output interface. The input/output interface is configured to receive code instructions or information. For example, the input interface inputs the first sequence in the foregoing aspects, and the output interface outputs a polar code encoded by performing the method in the foregoing aspects. The logic circuit is configured to execute the code instructions or perform the method in the foregoing aspects based on the information.

These aspects or other aspects of this application are more concise and easier to understand in descriptions of the following embodiments.

**BRIEF DESCRIPTION OF DRAWINGS**

FIG. 1 is a schematic diagram of an application scenario according to an embodiment of this application;
FIG. 2 is a schematic diagram of a structure of a communication process in a communication system;
FIG. 3 is a schematic diagram of an encoding process of a polar code;
FIG. 4 is a schematic diagram of sequence extension;
FIG. 5 is a schematic diagram of a polar encoding method according to an embodiment of this application;
FIG. 6 is a schematic diagram of another polar encoding method according to an embodiment of this application;
FIG. 7 is a schematic diagram of still another polar encoding method according to an embodiment of this application;
FIG. 8 is a schematic diagram of a polar encoding apparatus according to an embodiment of this application;
FIG. 9 is a schematic diagram of another polar encoding apparatus according to an embodiment of this application;
FIG. 10 is a schematic diagram of still another polar encoding apparatus according to an embodiment of this application;
FIG. 11 is a schematic diagram of another structure of a polar encoding apparatus according to an embodiment of this application; and
FIG. 12 is a schematic diagram of a structure of a chip in a polar encoding apparatus according to an embodiment of this application.

**DESCRIPTION OF EMBODIMENTS**

The following describes the technical solutions of this application with reference to accompanying drawings.

The technical solutions in embodiments of this application are applied to various communication systems, for example, a global system for mobile communication (global system for mobile communication, GSM), a code division multiple access (code division multiple access, CDMA) system, a wideband code division multiple access (wideband code division multiple access, WCDMA) system, a general packet radio service (general packet radio service, GPRS) system, a long term evolution (long term evolution, LTE) system, an LTE frequency division duplex (frequency division duplex, FDD) system, an LTE time division duplex (time division duplex, TDD) system, a universal mobile telecommunication system (universal mobile telecommunication system, UMTS), a worldwide interoperability for microwave access (worldwide interoperability for microwave access, WiMAX) communication system, and a 5th generation (5th generation, 5G) system, or a new radio (new radio, NR), or a future evolved communication system.

A terminal device in embodiments of this application may be a device having a radio transceiver function, and may be deployed on land, including an indoor device or an outdoor device, a handheld device, a wearable device, or a vehicle-mounted device. The terminal device may also be deployed on water (for example, on a ship), or may be deployed in the air (for example, on an airplane, a balloon, or a satellite). The terminal device may communicate with a core network through a radio access network (radio access network, RAN), and exchange a voice and/or data with the RAN. The terminal device may be a mobile phone (mobile phone), a tablet computer (Pad), a computer having a radio transceiver function, a mobile internet device (mobile internet device, MID), a wearable device, a virtual reality (virtual reality, VR) terminal device, an augmented reality (augmented reality, AR) terminal device, a wireless terminal in industrial control (industrial control), a wireless terminal in self-driving (self-driving), a wireless terminal in remote medical (remote medical), a wireless terminal in a smart grid (smart grid), or a wireless terminal in transportation safety (transportation safety), a wireless terminal in a smart city (smart city), a wireless terminal in a smart home (smart home), or the like. An application scenario is not limited in embodiments of this application. The terminal device may also be sometimes referred to as user equipment (user equipment, UE), a mobile station, a remote station, or the like. A specific technology, a device form, and a name that are used by the terminal device are not limited in embodiments of this application.

In embodiments of this application, a network device may include an evolved NodeB (NodeB, eNB, or e-NodeB, evolved NodeB) in a long term evolution (long term evolution, LTE) system or an LTE-advanced (LTE-advanced, LTE-A) system, for example, a conventional macro base station eNB and a micro base station eNB in a heterogeneous network scenario; or may include a next generation NodeB (next generation NodeB, gNB) in a 5th generation (5th generation, 5G) mobile communication technology new radio (new radio, NR) system; or may include a radio network controller (radio network controller, RNC), a NodeB (NodeB, NB), a base station controller (base station controller, BSC), a base transceiver station (base transceiver station, BTS), a transmission and reception point (transmission reception point, TRP), a home base station (for example, a home evolved NodeB, or a home NodeB, HNB), a baseband unit (base band unit, BBU), a baseband pool BBU pool, or a Wi-Fi access point (access point, AP), or the like; or may further include a centralized unit (centralized unit, CU) and a distributed unit (distributed unit, DU) in a cloud access network (cloud radio access network, Cloud RAN) system. This is not limited in embodiments of this application. In a split deployment scenario in which an access network device includes the CU and the DU, the CU supports protocols such as a radio resource control (radio resource control, RRC) protocol, a packet data convergence protocol (packet data convergence protocol, PDCP), and a service data adaptation protocol (service data adaptation protocol, SDAP), and the DU mainly supports a radio link control (radio link control, RLC) layer protocol, a media access control (media access control, MAC) layer protocol, and a physical layer protocol.

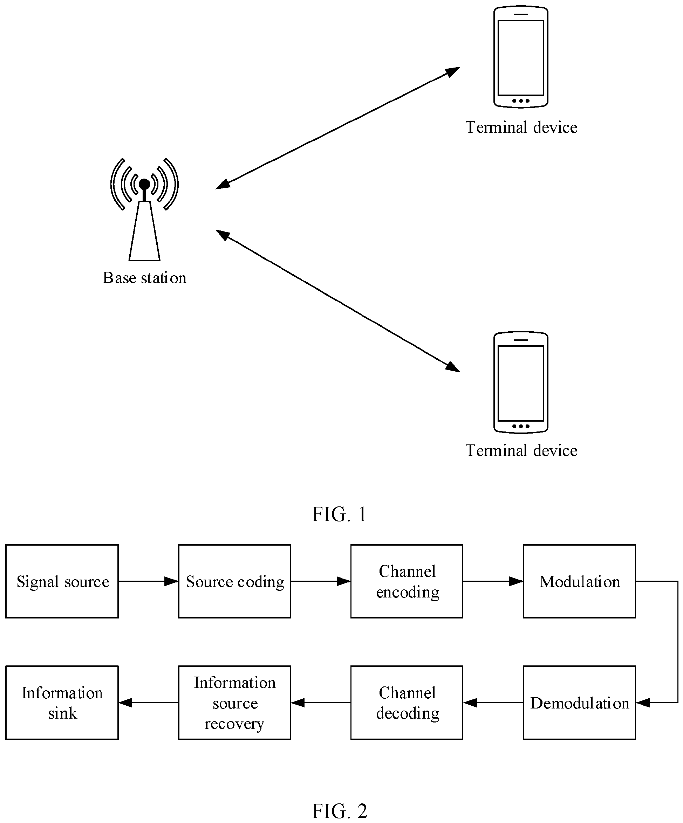

FIG. 1 is a schematic diagram of a scenario according to this application. The scenario includes a base station and a terminal device, and the base station provides a communication service for the terminal device. The base station transmits downlink data to the terminal. The data is encoded through channel encoding, and data obtained after channel encoding is transmitted to the terminal after constellation modulation. The terminal device transmits uplink data to the base station. The uplink data may also be encoded through channel encoding, and encoded data is transmitted to the base station after constellation modulation. An application scenario of this application may be used for communication between a base station and a terminal device in a 60 GHz frequency band.

Fast evolution of radio communication indicates that a 5G communication system will present some new features. Three most typical communication scenarios in the 5G communication system include:

1. eMBB scenario: Higher transmission rates (peak rate: 10 Gbit/s in uplink and 20 Gbibs in downlink) and higher spectral efficiency (peak spectral efficiency: 12 bit/(s Hz) in the uplink and 30 bit/(s Hz) in the downlink) are required.

2. mMTC scenario: Larger connection density ($1*10^6$ connections/$km^2$) and lower power consumption (a battery life of terminals can reach 15 years) are required.

3. URLLC scenario: Lower latency (uplink and downlink latency: 0.5 ms, that is, end-to-end latency is less than 1 ms), higher reliability (reaches 99.9999%, that is, a frame error rate within 1 ms is less than $10^{-6}$), a lower error layer, and the like are required. Requirements of these communication scenarios present a new challenge to an existing LTE technology.

As a most basic radio access technology, channel encoding is one of important research objects to meet a 5G communication requirement. FIG. 2 is a schematic diagram of a structure of a communication process in a communication system, and the communication process includes channel encoding and channel decoding.

After the Shannon theory is proposed, scholars from various countries have been devoted to finding an encoding/decoding method that can approach a Shannon limit and that has low complexity. Although a turbo code (turbo code) as a mainstream research direction and a re-proposed low-density parity-check code (low density parity check code, LDPC) have been well applied to LTE and worldwide interoperability for microwave access (world interoperability for microwave access, WiMAX), some important problems in 5G communication cannot be well resolved by using the two codes.

Future channel encoding is required to support a wider range of code rates with low complexity and good performance. In addition, different from LTE, eMBB and mMTC each have an important feature: medium and short packet transmission. Therefore, channel encoding is required to better support communication of such a code length. This also helps a control channel characterized by a short packet and a low code rate. URLLC further imposes a stricter requirement on data transmission reliability. For the code rates, currently the turbo code in the LTE cannot support excessively low and excessively high code rates. For medium and short packet transmission, the turbo code and the LDPC code can be difficult to achieve an ideal performance within a limited code length due to an encoding/decoding feature. For a long packet, although the turbo code and the LDPC code can approach the Shannon limit as a code length is extended (which is theoretical performance), the two codes never reach the theoretical performance. In addition, during implementation, the turbo code and the LDPC code have high complexity in an encoding/decoding implementation process. Therefore, in the 5G communication system, a new encoding technology is urgently required to resolve problems in a short packet, a code rate, reliability, and complexity in the conventional technology.

In 2009, Professor Arikan proposed an encoding manner based on channel polarization, and the encoding manner is referred to as a polar code. The polar code is a first channel encoding method that can be strictly proved to "reach" a channel capacity. The polar code has far better performance than that of the turbo code and the LDPC code for different code lengths, particularly for a limited code. In addition, the polar code has low computational complexity in encoding/decoding. These advantages enable the polar code to be widely used in 5G.

The polar code is a linear block code, a generator matrix is $G_N$, and an encoding process is

$$x_1^N = u_1^N G_N . \quad u_1^N = \left( u_1, u_2, \ldots, u_N \right)$$

is a binary row vector with a length (namely, a code length) of N; $G_N$ is an N×N matrix, and $G_N = F_2^{\otimes n}$ . Herein,

$$F_2 = \begin{bmatrix} 1 & 0 \\ 1 & 1 \end{bmatrix}$$, and n=log2 (N); and $F_2^{\otimes n}$ is defined

as a Kronecker (Kronecker) product of n matrices $F_2$.

In an encoding process of a polar code, some bits in $u_1^N$ are used to carry information and are referred to as information bits, and a set of indexes of the bits is denoted as A ; and the other bits are set to fixed values that are agreed on by a transmitting and receiving end in advance and are referred to as fixed bits, and a set of indexes of these bits is represented by a complementary set A$^c$ of A .

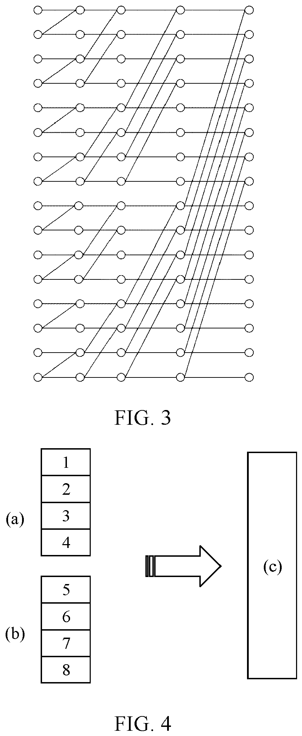

FIG. 3 is a schematic diagram of an encoding process of a polar code. As shown in FIG. 3, a hedge graph is used to indicate the encoding process of the polar code. $u_1^N$ is placed on a leftmost side of the hedge graph, and an n-order butterfly operation is sequentially performed from left to right, to obtain an encoding result

$X_1^N$ .

A key problem in polar code construction is to determine an information bit sequence number set A . In an early theoretical research phase, the set A is usually selected by using the following method: First, a polar channel error probability $P_e^{(i)}$ corresponding to a bit of a sequence number i is obtained by using a method such as density evolution (density evolution) or Gaussian approximation (Gaussian analysis), and K sequence numbers with a minimum value of $P_e^{(i)}$ are then selected to form the set A . In this method, $P_e^{(i)}$ needs to be calculated in different channel conditions. In other words, the method is a channel-dependent approach. This is difficult to be actually applied due to a variable channel in an actual scenario.

Further research shows that a polar code may be constructed by using a sequence. When the polar code is constructed, the information bit set A can be determined by reading only a corresponding sequence. Specifically, the sequence may use a polar channel sequence number to indicate a sequence of a selected information bit. For example, when a code length is 8, a sorting sequence in the sequence of selecting information bits is [1, 2, 3, 5, 4, 6, 7, 8]. When an information bit set A whose information length is K is constructed, only K subchannels need to be read from back to front as the information bit set A . For example, when K=2, A=[7, 8] is read from the foregoing sequence from back to front; or when K=4, A=[4, 6, 7, 8]. This sequence storage manner is easier to implement, and this form is also used in a 5G standard.

Currently, a polar code is selected as a channel encoding solution of a control channel in 5G, and a currently used sequence has a length of 1024. When channel encoding is performed by using a polar code with a sequence whose length is greater than 1024, long sequence construction has the following two challenges:

First, the used sequence has the length of 1024, and cannot be directly applied to longer polar code construction.

Second, optimal construction of a sequence of a polar code is very difficult. This is mainly because an SCL decoder is difficult to analyze, and existing research shows that the Polar code constructed through Gaussian approximation is not optimal in the SCL decoder, and no optimal construction is provided. At present, a short sequence is mainly constructed based on an artificial intelligence (artificial intelligence, AI)+search+large-scale simulation verification method. However, the long sequence is difficult to construct in this method because a search space exponential increases.

To resolve this problem, a feasible practice is to first construct an optimal short sequence (for example, an NR sequence with a length of 1 K), and then extend the sequence to a required length.

For ease of understanding, a schematic diagram shown in the FIG. 4 may be used for representation.

A queue (first in first out) may indicate a sequence of a polar code, and blocks (indicating subchannel numbers or bits) are put into the queue from top to bottom, and then numbers are sequentially read from bottom to top. As shown in FIG. 4, a to-be-extended basic sequence may be represented by using a sequence (a) whose length is N. A sequence (b) whose length is N may be obtained by adding N to each element in the basic sequence. The sequence (a) and the sequence (b) respectively correspond to a first half and a second half of subchannels of the polar code with a length of 2N.

As shown in FIG. 4, sequence extension may be considered as sequentially moving elements (that is, numbers 1-8 in the figure) in the two sequences (a) and (b) to a sequence (c) on the right, where the sequence (c) is an extended sequence whose length is 2N. When an element is determined to move from the sequence (a) or the sequence (b), an element at the bottom of the sequence (a) or the sequence (b) is moved to the sequence (c). In a process of moving an element, or in a process of extending a sequence, a key problem is to determine in what order to move the element from the sequence (a) or the sequence (b) to the sequence (c).

To implement the foregoing extension method, a common extension manner is mainly as follows.

Polarization weight (polarization weight, PW) sequence extension: When the N-long sequence is extended according to this method, a 2N-long PW sequence is first constructed directly. Specifically, when a 2N-long sequence including K information bits is constructed, an information bit set is first constructed based on the 2N-long PW sequence, a quantity of information bits obtained from the red queue and the blue queue is determined based on the information bit set, and then corresponding information bits are read from bottom to top separately.

However, performance of the sequence obtained through extension by using this approximation algorithm is poor. In addition, because a floating-point operation is related, extension complexity is also high.

This application provides a polar encoding method, to perform encoding based on a sequence obtained by extending a short sequence. This fully utilizes feature information of the short sequence, improves performance gain of the extended sequence, reduces complexity of sequence extension, and further improves encoding performance and reduces encoding complexity.

This application may be applied to application scenarios supporting a low power consumption service, supporting a high-throughput service, and supporting a latency-sensitive service.

It should be understood that the short sequence in embodiments of this application may be obtained through a large amount of search, simulation, and design, and includes abundant feature information of information bit construction of the polar code, especially feature construction applied to an SCL decoder. Alternatively, the short sequence in this application may be obtained in another manner. This is not limited in this application.

The encoding method in embodiments of this application is applied to a communication process between various communication devices. The communication device may be a terminal device, a network device that provides a network service for the terminal device, or the like. This is not limited in this application.

It should be understood that the extended sequence used in the encoding process in embodiments of this application may be extended in the encoding process, that is, may be performed online, or may be performed offline.

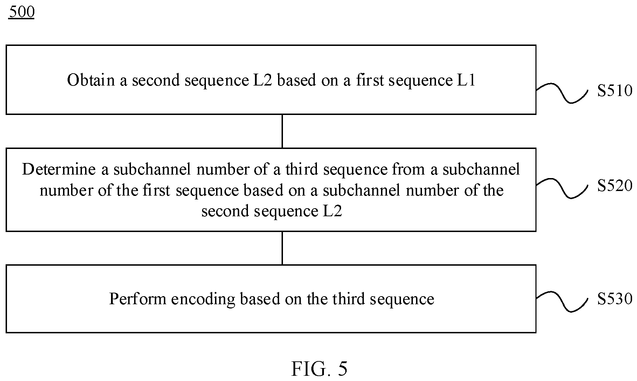

FIG. 5 is a schematic diagram of a polar encoding method according to an embodiment of this application. As shown in FIG. 5, the method includes steps S510 to S530. The following describes these steps in detail.

S510: Obtain a second sequence L2 based on a first sequence L1.

Optionally, the encoding method is applied to a polar code.

In an embodiment, the first sequence L1 includes $N_0$ subchannel numbers, the second sequence L2 includes $2^n*N_0$ subchannel numbers, and n is an integer greater than or equal to 1.

In an embodiment, the obtaining a second sequence L2 based on a first sequence L1 includes: determining that a subchannel number of the second sequence is

$$Q\_L1\left(\left\lceil \frac{i}{2^n} \right\rceil \right)$$

), where $\lceil \rceil$ indicates rounding up, i indicates a sequence number of the subchannel number, and i is greater than or equal to 1 and less than or equal to $2^n*N_0$.

Optionally, the first sequence may be a basic short sequence constructed by using an AI+search+large-scale simulation verification method.

S520: Determine a subchannel number of a third sequence from the subchannel number of the first sequence based on the subchannel number of the second sequence L2.

In an embodiment, the third sequence is a sequence that is obtained by extending the first sequence and the second sequence and that has a length of $2^n*N_0$, where the subchannel number of the third sequence L3 is the subchannel number of the first sequence L1 plus $j*N_0$, and j is greater than or equal to 0 and less than or equal to $2^n-1$.

In an embodiment, the determining a subchannel number of a third sequence from the subchannel number of the first sequence based on the subchannel number of the second sequence L2 includes: if the subchannel number of the second sequence L2 is greater than $(j*N_0)/2^n$ and less than or equal to $(j+1)*N_0/2^n$, determining the subchannel number of the third sequence L3 as: a $t_j$th subchannel number of the first sequence L1 plus $j*N_0$, where a value of $t_j$ is a previous value of $t_j$ plus 1, an initial value of $t_j$ is 1, and $t_j$ is greater than or equal to 1 and less than or equal to $N_0$.

S530: Perform encoding based on the third sequence.

In this embodiment of this application, for a manner of performing encoding based on the obtained third sequence to obtain the polar code, refer to the conventional technology. This application focuses on a sequence used during encoding. Therefore, the encoding manner of the polar code is not specifically described herein.

In this embodiment of this application, in an encoding process, encoding is performed based on the sequence obtained by extending the short sequence. This fully utilizes feature information of the short sequence, improves performance gain of the extended sequence, reduces complexity of sequence extension, and further improves encoding performance and reduces encoding complexity.

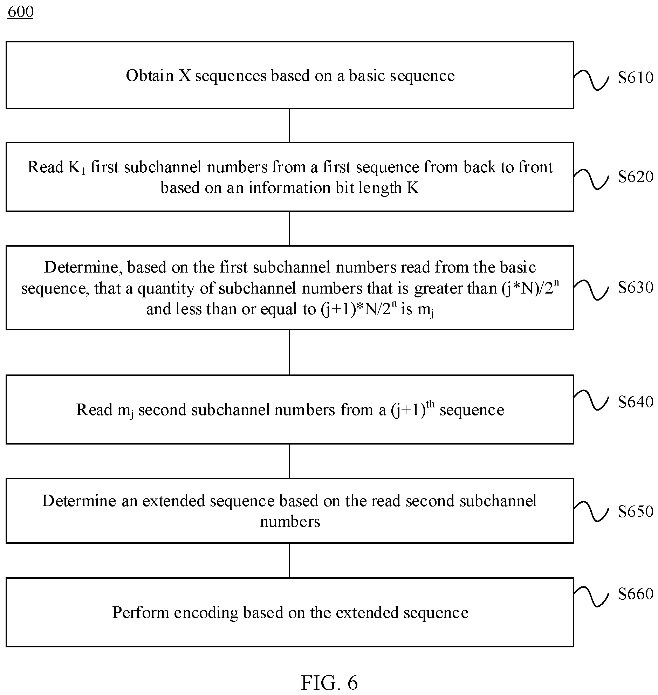

FIG. 6 is a schematic diagram of another polar encoding method according to an embodiment of this application. As shown in FIG. 6, the method includes steps S610 to 5660. The following describes these steps in detail.

S610: Obtain X sequences based on a basic sequence.

Optionally, the encoding method is applied to a polar code.

In an embodiment, the basic sequence includes $N_0$ subchannel numbers, each of the X sequences includes $2^n*N_0$ subchannel numbers, X is 1, 2, 3, ..., or $2°$, and n is an integer greater than or equal to 1.

Optionally, the first sequence may be a basic short sequence constructed by using an AI+search+large-scale simulation verification method.

S620: Read $K_1$ first subchannel numbers from the first sequence from back to front based on an information bit quantity k.

In an embodiment, the information bit quantity k is greater than or equal to 1 and less than or equal to $2^n*N_0$, $K_1$ is equal to $k/2^n$, and the information bit quantity k is an information bit quantity of an extended sequence obtained based on the basic sequence and the X sequences.

S630: Determine, based on the first subchannel numbers read from the first sequence, that a quantity of subchannel numbers that is greater than $(j*N_0)/2^n$ and less than or equal to $(j+1)*N_0/2^n$ is $m_j$, where j is greater than or equal to 0 and less than or equal to $2^n-1$, and $m_j$ is greater than or equal to 1 and less than or equal to $N_0$.

S640: Read $m_j$ second subchannel numbers from a $(j+1)^{th}$ sequence.

In an embodiment, when the information bit quantity $k \neq K_1 2^n$ n, $k-K_1 2^n$ third subchannel numbers are read from the X sequences.

S650: Determine the extended sequence based on the read second subchannel numbers.

In an embodiment, the determining the extended sequence based on the read subchannel numbers includes: determining, taking the information bit quantity k as 1 to M and based on the second subchannel number read when the information bit quantity is k and k-1, that a sequence of the newly added second subchannel number is a $k^{th}$ bit, and repeating the foregoing steps to obtain the extended sequence.

S660: Perform encoding based on the extended sequence.

In this embodiment of this application, for a manner of performing encoding based on the extended sequence to obtain the polar code, refer to the conventional technology. This application focuses on a sequence used during encoding. Therefore, the encoding manner of the polar code is not specifically described herein.

In this embodiment of this application, in an encoding process, encoding is performed based on the sequence obtained by extending the short sequence. This fully utilizes feature information of the short sequence, improves performance gain of the extended sequence, reduces complexity of sequence extension, and further improves encoding performance and reduces encoding complexity.

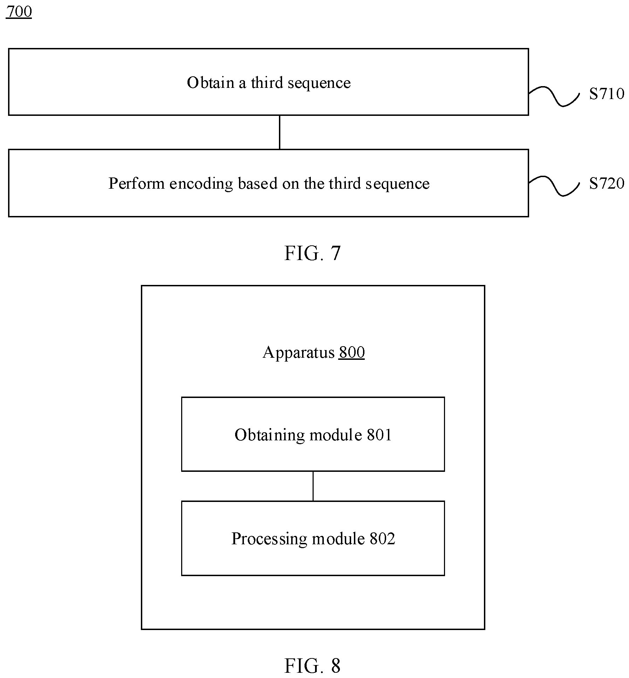

FIG. 7 is a schematic diagram of still another encoding method according to an embodiment of this application. As shown in FIG. 7, the method includes steps S710 and 5720. The following describes the two steps in detail.

S710: Obtain a third sequence.

Optionally, the encoding method is applied to a polar code.

In an embodiment, a length of the third sequence is $2N_0$, the third sequence is indicated by a fourth sequence whose length is $2N_0$ and a fifth sequence whose length is $N_0$, elements of the fourth sequence and the fifth sequence meet at least one of a first condition or a second condition: The first condition is L4(2j-1)=L4(2j), and the second condition is $L5(_j)<N_0/2$ and L4(2j)=0, or the second condition is $L5(j)>N_0/2$ and L4(2j)=1, where j is an element sequence number, and j is greater than or equal to 1 and less than or equal to N.

In an embodiment, the fourth sequence may be as follows: When an $i^{th}$ element of the third sequence is less than or equal to $N_0$, an $i^{th}$ element of the fourth sequence is 0; or when the $i^{th}$ element of the third sequence is greater than $N_0$, the $i^{th}$ element of the fourth sequence is 1, where i is an element sequence number, and i is greater than or equal to 1 and less than or equal to $2N_0$.

In an embodiment, the fifth sequence may be a set of elements less than or equal to $N_0$ in elements of the third sequence.

S720: Perform encoding based on the third sequence.

In this embodiment of this application, for a manner of performing encoding based on the obtained third sequence to obtain the polar code, refer to the conventional technology. This application focuses on a sequence used during encoding. Therefore, the encoding manner of the polar code is not specifically described herein.

It should be understood that the third sequence used in the encoding method in this embodiment of this application may be a sequence that directly meets the foregoing static limitation condition, and an $N_0$ sequence including an element less than or equal to $N_0$ or an element greater than $N_0$ extracted from the third sequence meets the foregoing limitation condition. In other words, the third sequence appearing as a whole can meet the foregoing static limitation condition, or if a part of the third sequence meets the foregoing static limitation addition, it can be determined that the third sequence uses the sequence extension method used in the encoding method in this embodiment of this application.

In this embodiment of this application, encoding is performed based on the third sequence with a sequence for indication meeting a preset condition. The third sequence is an extended sequence. The third sequence fully utilizes feature information of the short sequence, improves performance gain of the extended sequence, reduces complexity of sequence extension, and further improves encoding performance and reduces encoding complexity.

The following provides an embodiment of a sequence extension process of an extended sequence used in an encoding process of this application.

The following describes in detail the sequence extension process in this embodiment.

(1) Obtain a sequence L2 for reference based on a basic construction sequence L1, and generate the sequence L2 for reference in the following manner:

$$Q\_L2(i)=Q\_L1\left(\left\lceil \frac{i}{2^n} \right\rceil\right).$$

$Q\_L2(i)$ indicates an $i^{th}$ element in the sequence L2, and an element number i is 1, 2, ..., or $2^n*N_0$. L1 is a basic sequence whose length is $N_0$, each element in L1 may indicate a different subchannel number, and the sequence L1 may be a basic short sequence constructed based on an AI+search+large-scale simulation verification method.

(2) Extend the basic construction sequence L1 to a target construction sequence L3 based on the sequence L2 for reference:

Initialize $t_j=1$; and
if $(j*N_0)/2^n < Q\_L2(i) \leq (j+1)*N_0/2^n$, determine $Q\_L3(i)$ as:
$Q\_L3(i)=Q\_L1(t_j)+j*N_0$, $t_j=t_j+1$.
j is greater than or equal to 0 and less than or equal to $2^n-1$, an initial value of $t_j$ is set to 1, $1 \leq t_j \leq N_0$, $Q\_L1(t_j)$ is a subchannel number of the first sequence, and $Q\_L3(i)$ is an $i^{th}$ subchannel number of the third sequence.

It should be understood that, in this embodiment of this application, the length $N_0$ of the basic construction sequence may be 1024, and may be an NR sequence. If the foregoing extension step is repeatedly performed, a target construction sequence whose length is N=2048, 4096, 8192, 16384, or the like may be obtained.

It should be understood that the sequence extension process in this embodiment of this application may be performed online, or may be performed offline. This is not limited in this application.

In this embodiment of this application, a sequence with a required length is obtained by extending the basic short sequence. This fully utilizes feature information of the short sequence, and improves performance gain of the extended sequence. In addition, the sequence extension method in this application does not need any floating-point operation and is simple to implement. This reduces complexity of sequence extension.

The following provides an embodiment of a sequence extension process of an extended sequence used in another encoding process of this application. A sequence L1 whose initial sequence length is $N_0$ is given, and is extended to a sequence L3 whose length is $2N_0$ in this embodiment of this application.

It should be understood that this embodiment of this application is another description form of the sequence extension method in this application.

It should be understood that the sequence L1 includes $N_0$ elements, and each element may indicate a different subchannel number. For example, L1 may be a sequence whose length is 8, and L1 may indicate [1, 2, 3, 5, 4, 6, 7, 8]. It should be understood that the sequence L1 may be a basic short sequence constructed based on an AI+search+large-scale simulation verification method.

The following describes in detail the sequence extension process in this embodiment of this application.

(1) Add $N_0$ to all elements in the sequence L1, to obtain a sequence L2, for example, L2 may be represented as [9, 10, 11, 13, 12, 14, 15, 16].
(2) Give an information bit k and when k is an even number, $K_1 =k/2$, and p=0; or
when k is an odd number, $K_1 =(k-1)/2$, and p=1, where $K_1$ is a quantity of subchannel numbers read from the sequence L1, or a quantity of elements read from L1.
(3) Read $K_1$ subchannel numbers from the initial sequence L1 from back to front, and count a quantity of numbers less than or equal to $N_0/2$ as m1, and a quantity of numbers greater than $N_0/2$ as m2, where m1+m2=$K_1$; and

further, determine a $(K_1+1)^{th}$ subchannel number t from the sequence L1 from back to front, and if t is less than or equal to $N_0/2$, M=1; or otherwise, it is assumed that M=2.

(4) Further, read m1 subchannel numbers from L1 from back to front, and read m2 subchannel numbers from L2 from back to front;

if p=1, that is, when k is an odd number, when M=1, read a next subchannel number from the sequence L1, or when M=2, further read a next subchannel number from the sequence L2; and set subchannels corresponding to these numbers as information bits, and other subchannels are set as frozen bits, to obtain construction of a polar code.

(5) Compare information bit construction obtained when the information bit quantity is k and the information bit quantity is k-1, locate a subchannel to which the information bits are newly added, denote reliability order of the subchannel as k, and repeatedly perform the foregoing process, to obtain an extended sequence L3.

It should be understood that the foregoing process is to extend a sequence whose length is $N_0$ to a sequence whose length is $2N_0$. Further, in this embodiment of this application, the sequence whose length is $N_0$ can be extended to a sequence whose length is $2^n$ times the length of $N_0$. In this case, the foregoing steps may be simplified as follows:

1. Obtain x sequences based on a basic sequence, where x is 1, 2, 3, ..., or $2^n$, that is, a first sequence, a second sequence, a third sequence, ..., or a $2^{nth}$ sequence, and the like. The first sequence, the second sequence, and the like may be each element of the basic sequence L1 plus $(x-1)*N_0$.
2. Read $K_1$ subchannel numbers from the basic sequence based on an information bit quantity k, where the information bit quantity k is greater than or equal to 1 and less than or equal to M, and $K_1$ is equal to $k/2^n$, M is a length of an extended sequence obtained by extending the basic sequence and the first sequence, the second sequence, the third sequence, ..., and the $2^{nth}$ sequence, M is $2^n$ times the length of $N_0$, and n is an integer greater than or equal to 1.
3. Determine, based on $K_1$ subchannel numbers read from the basic sequence, that a quantity of subchannel numbers that is greater than $(j*N_0)/2^n$ and less than or equal to $(j+1)*N/2^n$ is $m_j$, where j is greater than or equal to 0 and less than or equal to $2^n-1$, and $m_j$ is greater than or equal to 1 and less than or equal to $N_0$.
4. Read the $m_j$ subchannel numbers from a $(j+1)^{th}$ sequence.
5. When the information is a length $k \neq K_1 2^n$, read $k-K_1 2^n$ subchannel numbers from the first sequence, the second sequence, the third sequence..., and a $2^{nth}$ sequence.
6. Determine the extended sequence based on the read subchannel number.

In this embodiment of this application, a sequence with a required length is obtained by extending the basic short sequence. This fully utilizes feature information of the short sequence, and improves performance gain of the extended sequence. In addition, the sequence extension method in this application does not need any floating-point operation and is simple to implement. This reduces complexity of sequence extension.

It should be understood that the foregoing sequence extension process may be performed online, or may be performed offline. This is not limited in this application.

It should be understood that the sequence in this embodiment of this application may be stored by using a Q sequence. For example, for a polar code whose code length $N_0=8$, a Q sequence corresponding to the polar code may be [1, 2, 3, 5, 4, 6, 7, 8], which indicates that subchannels sorted in descending order based on reliability are [8, 7, 6, 4, 5, 3, 2, 1]. When a polar code whose information bit quantity is k is constructed, k positions are read from the Q sequence from back to front as information bits, and the remaining N-k positions are used as frozen bits. For example, when an information bit with a length of 4 is constructed, four positions such as 8, 7, 6, and 4, are sequentially read from back to front as information bits, and the other four positions such as 5, 3, 2, and 1, are used as frozen bits.

Alternatively, optionally, a Z sequence may be used for storage. An $i^{th}$ element of the Z sequence indicates a reliability order of an $i^{th}$ subchannel. The Z sequence is in a one-to-one correspondence with the Q sequence, and is merely an implementation of this application, and does not need to be additionally created. Therefore, this is within the coverage scope of this application.

It should be understood that, when the polar code is constructed by using the constructed polar code sequence, only k subchannel numbers need to be sequentially read from back to front, and the k subchannel numbers are used as information bits, and the other positions are used as frozen bits.

Optionally, some middle bits may be pre-frozen to reduce complexity. For example, for a Polar code whose length is $N_0$, after completing the first half of decoding, the SCL decoder selects only one path to continue the second half of decoding. In this way, when the second half of the decoding is performed, the decoder of the first half of the decoding can be completely reused, saving storage and a chip area. It should be noted that only one path may be reserved after 1/4 of decoding, 1/8 of decoding, and the like are decoded first. Specific implementation of the path does not need to be additionally created. Therefore, this is within the coverage scope of this application.

The foregoing constructed polar code sequence supports the foregoing SCL decoder that forcibly reserves a path. When the polar code is constructed, $k+x1$ information bit positions are first read according to the foregoing method, and $x1$ information bit positions with a maximum index are further selected from information bit positions less than or equal to $N_0/2$ as frozen bits. During decoding, these frozen bits are first decoded as information bits, and then a path in which these positions are decoded into 0 is selected to continue decoding.

The following provides an embodiment of sequence detection of an extended sequence used in an encoding process of this application.

    1. Obtain an extended sequence L3.

    2. Obtain a sequence for indication L4 and a base sequence L5 based on the extended sequence L3, where the sequence for indication L4 is as follows:

When an $i^{th}$ element in the extended sequence L3 is less than or equal to $N_0$, an $i^{th}$ element in the sequence for indication L4 is 0, or when an $i^{th}$ element in the extended sequence L3 is greater than $N_0$, an $i^{th}$ element in the sequence for indication L4 is 1, where i is an element sequence number, and i is greater than or equal to 1 and less than or equal to $2N_0$, or may indicate:

If L3(i) is less than or equal to $N_0$, L4(i)=0; otherwise, L4(i)=1. L3(i) and L4(i) are respectively the $i^{th}$ element of L3 and the $i^{th}$ element of L4, and $1 \leq i \leq 2N_0$.

The base sequence L5 may indicate a set of elements less than or equal to $N_0$ in the elements of the extended sequence L3, or may indicate extracted elements less than or equal to $N_0$ in the extended sequence L3, and a length of the base sequence is N.

3. Determine whether the sequence for indication L4 and the base sequence L5 meet at least one of the following two conditions:

    First condition: L4(2j-1)=L4(2j).
    Second condition: $L5(j) < N_0/2$ and L4(2j)=0, or the second condition is $L5(j) > N_0/2$ and L4(2j)=1.
    j is an element sequence number, and j is greater than or equal to 1 and less than or equal to N.

It should be understood that the extended sequence used in the encoding method in this embodiment of this application may be a sequence that directly meets the foregoing static limitation condition, and an $N_0$ sequence including an element less than or equal to $N_0$ or an element greater than $N_0$ extracted from the extended sequence meets the foregoing limitation condition. In other words, the third sequence appearing as a whole can meet the foregoing static limitation condition, or if a part of the third sequence meets the foregoing static limitation addition, it can be determined that the third sequence uses the sequence extension method used in the encoding method in this embodiment of this application.

In this embodiment of this application, the extended sequence is detected by using the sequence for indication and the base sequence. The extended sequence is an extended sequence obtained based on an extension manner used in the encoding method in this embodiment of this application. The extended sequence in this embodiment of this application fully utilizes feature information of the short sequence, improves performance of the extended sequence, reduces complexity of sequence extension, and further improves encoding performance and reduces encoding complexity.

FIG. 8 is a schematic diagram of a polar encoding apparatus according to an embodiment of this application. As shown in FIG. 8, the apparatus 800 includes an obtaining module 801 and a processing module 802. The apparatus 800 may be configured to implement an encoding function of the communication device in any one of the foregoing method embodiments. For example, the apparatus 800 may be a communication device including a terminal device or a network device (such as a base station) that provides a network service for the terminal device.

The apparatus 800 may serve as a communication device to obtain a sequence, and perform the step of processing the sequence by the communication device in the foregoing method embodiments. The obtaining module 801 may be configured to support the apparatus 800 in communication, for example, performing obtaining actions performed by the communication device in FIG. 5 to FIG. 7. The processing module 802 may be configured to support the apparatus 800 in performing processing actions in the foregoing methods, for example, performing processing actions performed by the communication device in FIG. 5 to FIG. 7. For details, refer to the following descriptions:

The obtaining module is configured to obtain a second sequence L2 based on a first sequence L1, where the first sequence L1 includes $N_0$ subchannel numbers, the second sequence L2 includes $2^n * N_0$ subchannel numbers, and n is an integer greater than or equal to 1. A processing module is configured to determine a subchannel number of a third sequence from a subchannel number of the first sequence based on a subchannel number of the second sequence L2, where the third sequence is a sequence that is obtained by extending the first sequence and the second sequence and that has a length of $2^n * N_0$, the subchannel number of the third sequence L3 is the subchannel number of the first sequence L1 plus $j * N_0$, where j is greater than or equal to 0 and less than or equal to $2^n - 1$. The processing module is further configured to perform encoding based on the third sequence.

Optionally, the processing module is specifically configured to: if the subchannel number of the second sequence L2 is greater than $(j * N_0)/2^n$ and less than or equal to $(j+1) * N_0/2^n$, determine the subchannel number of the third sequence L3 as: a $t_j^{th}$ subchannel number of the first sequence L1 plus $j * N_0$, where a value of $t_j$ is a

previous value of $t_j$ plus 1, an initial value of $t_j$ is 1, and $t_j$ is greater than or equal to 1 and less than or equal to $N_0$.

Optionally, the processing module is specifically configured to: determine that the subchannel number of the second sequence is

$$Q\_L1\left(\left\lceil \frac{i}{2^n} \right\rceil\right)$$

), where $\lceil\ \rceil$ indicates rounding up, i indicates a sequence number of the subchannel number, and i is greater than or equal to 1 and less than or equal to $2^{n*}N_0$.

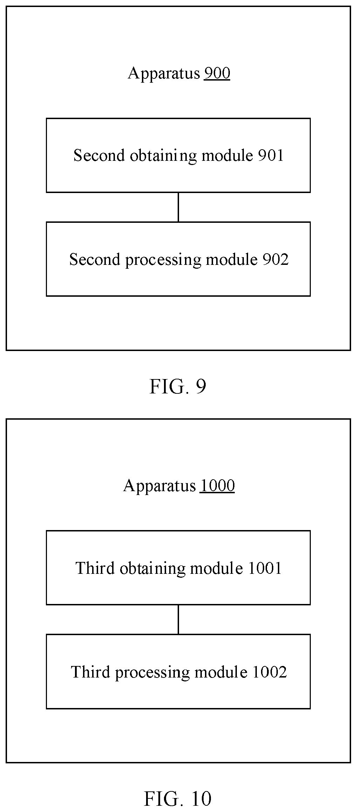

FIG. 9 is a schematic diagram of another polar encoding apparatus according to an embodiment of this application. As shown in FIG. 9, the apparatus 900 includes a second obtaining module 901 and a second processing module 902. The apparatus 900 may be configured to implement an encoding function of the communication device in any one of the foregoing method embodiments. For example, the apparatus 900 may be a communication device including a terminal device or a network device (such as a base station) that provides a network service for the terminal device.

The apparatus 900 may serve as a communication device to obtain a sequence, and perform the step of processing the sequence by the encoding apparatus in the foregoing method embodiments. The second obtaining module 901 may be configured to support the apparatus 900 in communication, for example, performing obtaining actions performed by the communication device in FIG. 5 to FIG. 7. The second processing module 902 may be configured to support the apparatus 900 in performing processing actions in the foregoing methods, for example, performing processing actions performed by the communication device in FIG. 5 to FIG. 7. For details, refer to the following descriptions:

The second obtaining module is configured to obtain X sequences based on a basic sequence, where the basic sequence includes $N_0$ subchannel numbers, each of the X sequences includes $2^{n*}N_0$ subchannel numbers, X is 1, 2, 3, ..., or $2^n$, and n is an integer greater than or equal to 1. The second processing module is configured to read $K_1$ first subchannel numbers from the basic sequence from back to front based on an information bit quantity k, where the information bit quantity k is greater than or equal to 1 and less than or equal to $2^{n*}N_0$, $K_1$ is equal to $k/2^n$, and the information bit quantity k is an information bit quantity of an extended sequence obtained based on the basic sequence and the X sequences. The second processing module is further configured to: determine, based on the first subchannel number read from the basic sequence from back to front, that a quantity of subchannel numbers that is greater than $(j*N_0)/2^n$ and less than or equal to $(j+1)*N_0/2^n$ is $m_j$, where j is greater than or equal to 0 and less than or equal to $2^n-1$, and $m_j$ is greater than or equal to 1 and less than or equal to $N_0$; read $m_j$ second subchannel numbers from a $(j+1)^{th}$ sequence from back to front; determine the extended sequence based on the read second subchannel numbers; and perform encoding based on the extended sequence.

Optionally, the second processing module is further configured to: when the information bit quantity $k \neq K_1 2^n$ n, read $k-K_1 2^n$ third subchannel numbers from the X sequences.

Optionally, the second processing module is specifically configured to: determine, taking the information bit quantity k as 1 to M and based on the second subchannel number read when the information bit quantity is k and k-1, that a sequence of the newly added second subchannel number is a $k^{th}$ bit, and repeat the foregoing steps to obtain the extended sequence.

FIG. 10 is a schematic diagram of still another polar encoding apparatus according to an embodiment of this application. As shown in FIG. 10, the apparatus 1000 includes a third obtaining module 1001 and a third processing module 1002. The apparatus 1000 may be configured to implement an encoding function of the communication device in any one of the foregoing method embodiments. For example, the apparatus 1000 may be a communication device including a terminal device or a network device (such as a base station) that provides a network service for the terminal device.

The apparatus 1000 may serve as a communication device to obtain a sequence, and perform the step of processing the sequence by the communication device in the foregoing method embodiments. The obtaining module 1001 may be configured to support the apparatus 1000 in communication, for example, performing obtaining actions performed by the communication device in FIG. 5 to FIG. 7. The processing module 1002 may be configured to support the apparatus 1000 in performing processing actions in the foregoing methods, for example, performing processing actions performed by the encoding apparatus in FIG. 5 to FIG. 7. For details, refer to the following descriptions:

The third obtaining module is configured to obtain a third sequence, where a length of the third sequence is $2N_0$, the third sequence is indicated by a fourth sequence whose length is $2N_0$ and a fifth sequence whose length is $N_0$, elements of the fourth sequence and the fifth sequence meet at least one of a first condition or a second condition: the first condition is L4(2j-1)=L4(2j), and the second condition is L5(j)<$N_0$/2 and L4(2j)=0, or the second condition is L5(j)>$N_0$/2 and L4(2j)=1, j is an element sequence number, and j is greater than or equal to 1 and less than or equal to N. The third processing module is configured to perform encoding based on the third sequence.

Optionally, the fourth sequence is as follows: when an $i^{th}$ element of the third sequence is less than or equal to $N_0$, an $i^{th}$ element of the fourth sequence is 0; or when the $i^{th}$ element of the third sequence is greater than $N_0$, the $i^{th}$ element of the fourth sequence is 1, where i is an element sequence number, and i is greater than or equal to 1 and less than or equal to $2N_0$.

Optionally, the fifth sequence is a set of elements less than or equal to $N_0$ in elements of the third sequence.

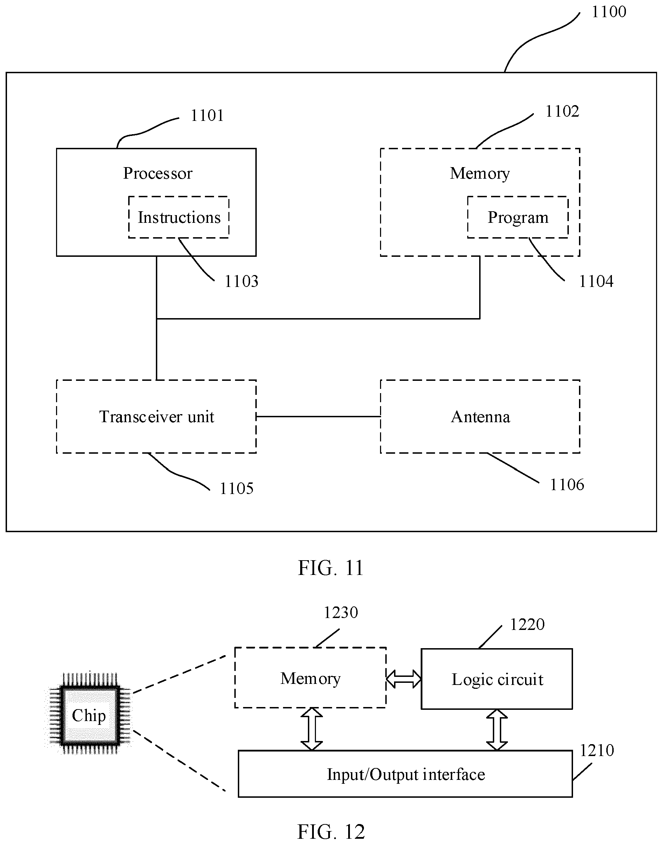

FIG. 11 is a schematic diagram of another structure of a polar encoding apparatus according to an embodiment of this application. The communication apparatus 1100 may be configured to implement the method that is described in the foregoing method embodiments and that is about the communication device including the terminal device or the network device. The communication apparatus 1100 may be a chip or a network device.

The communication apparatus 1100 includes one or more processors 1101. The one or more processors 1101 may support the communication apparatus 1100 in implementing the polar encoding methods in FIG. 5 to FIG. 7. The processor 1101 may be a general-purpose processor or a dedicated processor. For example, the processor 1101 may be a central processing unit (central processing unit, CPU) or a baseband processor. The baseband processor may be configured to process communication data. The CPU may be configured to control the communication apparatus (for example, a network device, a terminal device, or a chip) to execute a software program, and process data of the software program. The communication apparatus 1100 may further include a transceiver unit 1105, configured to input (receive) and output (send) a signal.

For example, the communication apparatus 1100 may be a chip, and the transceiver unit 1105 may be an input and/or output circuit of the chip; or the transceiver unit 1105 may be a communication interface of the chip, and the chip may be used as a component of a terminal device, a network device, or another radio communication device.

FIG. 12 is a schematic diagram of a structure of a chip in a polar encoding apparatus according to an embodiment of this application. As shown in the figure, the chip may include an input/output interface 1210, a logic circuit 1220, and a memory 1230. The memory 1230 is configured to store instructions. The input/output interface 1210 may be configured to receive code instructions or information. For example, the input/output interface 1210 may be configured to input instructions for obtaining the third sequence by using the first sequence and the second sequence in the polar encoding methods in FIG. 5 to FIG. 7 and performing polar encoding, or the input/output interface 1210 outputs a polar code that is encoded by performing the polar encoding methods in FIG. 5 to FIG. 7. The logic circuit 1220 is configured to execute the instructions stored in the memory 1230, or the logic circuit 1220 enables, based on the code instructions or information received from the input/output interface 1210, the chip implements the polar encoding methods in FIG. 5 to FIG. 7.

The communication apparatus 1100 may include one or more memories 1102. The memory 1102 stores a program 1104, and the program 1104 may be run by the processor 1101 to generate instructions 1103, so that the processor 1101 performs, based on the instructions 1103, the method described in the foregoing method embodiments. Optionally, the memory 1102 may further store data. Optionally, the processor 1101 may further read data stored in the memory 1102. The data and the program 1104 may be stored at a same storage address, or the data and the program 1104 may be stored at different storage addresses.

The processor 1101 and the memory 1102 may be disposed separately, or may be integrated together, for example, integrated on a board or integrated into a system on chip (system on chip, SOC).

The communication apparatus 1100 may further include a transceiver unit 1105 and an antenna 1106. The transceiver unit 1105 may be referred to as a transceiver machine, a transceiver circuit, a transceiver, and is configured to implement a transceiver function of the communication apparatus through the antenna 1106.

It should be understood that steps in the foregoing method embodiments may be implemented by using a logic circuit in a form of hardware or instructions in a form of software in the processor 1101. The processor 1101 may be a CPU, a digital signal processor (digital signal processor, DSP), an application-specific integrated circuit (application-specific integrated circuit, ASIC), a field programmable gate array (field programmable gate array, FPGA) or another programmable logic device, such as a discrete gate, a transistor logic device, or a discrete hardware component.

In the several embodiments provided in this application, it should be understood that the disclosed apparatus and method may be implemented in other manners. For example, the foregoing described apparatus embodiments are merely examples. For example, division into modules is merely logical function division and there may be other division during actual implementation.

When the method in embodiments of this application is implemented in a form of a software functional unit and sold or used as an independent product, the method may be stored in a computer-readable storage medium. Based on such an understanding, the technical solutions of this application or a part of the technical solutions may be implemented in a form of a software product. The computer software product is stored in a storage medium, and includes several instructions for indicating a computer device (which may be a personal computer, a server, a network device, or the like) to perform all or a part of the steps of the methods described in embodiments of this application. The storage medium includes at least any medium, for example, a USB flash drive, a removable hard disk, a read-only memory (read-only memory, ROM), a random access memory (random access memory, RAM), a magnetic disk, an optical disc, or the like that can store program code. The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. Apolar encoding method, comprising:

   obtaining a second sequence L2 based on a first sequence L1, wherein the first sequence L1 comprises $N_0$ subchannel numbers, the second sequence L2 comprises $2^n*N_0$ subchannel numbers, and n is an integer greater than or equal to 1;
   determining a subchannel number of a third sequence from a subchannel number of the first sequence based on a subchannel number of the second sequence L2, wherein the third sequence is a sequence that is obtained by extending the first sequence and the second sequence and that has a length of $2^n*N_0$, and the subchannel number of the third sequence L3 is the subchannel number of the first sequence L1 plus $j*N_0$, wherein j is greater than or equal to 0 and less than or equal to $2^n-1$; and
   performing encoding based on the third sequence.

2. The method according to claim 1, wherein the determining a subchannel number of a third sequence from a subchannel number of the first sequence based on a subchannel number of the second sequence L2 comprises:
   if the subchannel number of the second sequence L2 is greater than $(j*N_0)/2^n$ and less than or equal to $(j+1)*N_0/2^n$, determining the subchannel number of the third sequence L3 as:
   a $t_j$th subchannel number of the first sequence L1 plus $j*N_0$, wherein a value of $t_j$ is a previous value of $t_j$ plus 1, an initial value of $t_j$ is 1, and $t_j$ is greater than or equal to 1 and less than or equal to $N_0$.

3. The method according to claim 1 or 2, wherein the obtaining a second sequence L2 based on a first sequence L1 comprises:
   determining that the subchannel number of the second sequence is

   $$Q\_L1\left(\left\lceil \frac{i}{2^n} \right\rceil\right)$$

   ), wherein $\lceil \; \rceil$ indicates rounding up, i indicates a sequence number of the subchannel number, and i is greater than or equal to 1 and less than or equal to $2^n*N_0$.

4. Apolar encoding apparatus, comprising:

   an obtaining module, configured to obtain a second sequence L2 based on a first sequence L1, wherein the first sequence L1 comprises $N_0$ subchannel numbers, the second sequence L2 comprises $2^n*N_0$ subchannel numbers, and n is an integer greater than or equal to 1; and
   a processing module, configured to determine a subchannel number of a third sequence from a subchannel number of the first sequence based on a subchannel number of the second sequence L2, wherein the third sequence is a sequence that is obtained by extending the first sequence and the second sequence and that has a length of $2^n*N_0$, and the subchannel number of the third sequence L3 is the subchannel number of the first sequence L1 plus $j*N_0$, wherein j is greater than or equal to 0 and less than or equal to $2^n-1$, wherein
   the processing module is further configured to perform encoding based on the third sequence.

5. The apparatus according to claim 4, wherein the processing module is specifically configured to:
   if the subchannel number of the second sequence L2 is greater than $(j*N_0)/2^n$ and less than or equal to $(j+1)*N_0/2^n$, determining the subchannel number of the third sequence L3 as:
   a $t_j$th subchannel number of the first sequence L1 plus $j*N_0$, wherein a value of $t_j$ is a previous value of $t_j$ plus 1, an initial value of $t_j$ is 1, and $t_j$ is greater than or equal to 1 and less than or equal to $N_0$.

6. The apparatus according to claim 4 or 5, wherein the processing module is specifically configured to:
   determine that the subchannel number of the second

   $$Q\_L1\left(\left\lceil \frac{i}{2^n} \right\rceil\right)$$

   sequence is ), wherein $\lceil \; \rceil$ indicates rounding up, i indicates a sequence number of the subchannel number, and i is greater than or equal to 1 and less than or equal to $2^n*N_0$.

7. A polar encoding method, comprising: obtaining X sequences based on a basic sequence, wherein the basic sequence comprises $N_0$ subchannel numbers, each of the X sequences comprises $2^n*N_0$ subchannel numbers, X is 1, 2, 3, ..., or $2^n$, and n is an integer greater than or equal to 1;

   reading $K_1$ first subchannel numbers from the basic sequence from back to front based on an information bit quantity k, wherein the information bit quantity k is greater than or equal to 1 and less than or equal to $2^n*N_0$, $K_1$ is equal to $K/2^n$, and the information bit quantity k is an information bit quantity of an extended sequence obtained based on the basic sequence and the X sequences;

determining, based on the first subchannel number read from the basic sequence, that a quantity of subchannel numbers that is greater than $(j*N_0)/2^n$ and less than or equal to $(j+1)*N_0/2^n$ is $m_j$, wherein j is greater than or equal to 0 and less than or equal to $2^n-1$, and $m_j$ is greater than or equal to 1 and less than or equal to $N_0$;

reading $m_j$ second subchannel numbers from a $(j+1)^{th}$ sequence from back to front;

determining the extended sequence based on the read second subchannel numbers; and performing encoding based on the extended sequence.

8. The method according to claim 7, wherein the method further comprises: when the information bit quantity $k \neq K_1 2^n$ n, reading $K-K_1 2^n$ third subchannel numbers from the X sequences.

9. The method according to claim 7 or 8, wherein the determining the extended sequence based on the read second subchannel numbers comprises: determining, taking the information bit quantity k as 1 to M and based on the second subchannel number read when the information bit quantity is k and k-1, that a sequence of the newly added second subchannel number is a $k^{th}$ bit, and repeating the foregoing steps to obtain the extended sequence.

10. A polar encoding apparatus, comprising: a second obtaining module, configured to obtain X sequences based on a basic sequence, wherein the basic sequence comprises $N_0$ subchannel numbers, each of the X sequences comprises $2^n*N_0$ subchannel numbers, X is 1, 2, 3, ..., or $2^n$, and n is an integer greater than or equal to 1; and

a second processing module, configured to read $K_1$ first subchannel numbers from the basic sequence from back to front based on an information bit quantity k, wherein the information bit quantity k is greater than or equal to 1 and less than or equal to $2^n*N_0$, $K_1$ is equal to $K/2^n$, and the information bit quantity k is an information bit quantity of an extended sequence obtained based on the basic sequence and the X sequences wherein

the second processing module is further configured to: determine, based on the first subchannel number read from the basic sequence, that a quantity of subchannel numbers that is greater than $(j*N_0)/2^n$ and less than or equal to $(j+1)*N_0/2^n$ is $m_j$, wherein j is greater than or equal to 0 and less than or equal to $2^n-1$, and $m_j$ is greater than or equal to 1 and less than or equal to $N_0$; read $m_j$ second subchannel num-

bers from a $(j+1)^{th}$ sequence from back to front; determine the extended sequence based on the read second subchannel numbers; and perform encoding based on the extended sequence.

11. The apparatus according to claim 10, wherein the second processing module is further configured to: when the information bit quantity $k \neq K_1 2^n$ n, read $K-K_1 2^n$ third subchannel numbers from the X sequences.

12. The apparatus according to claim 10 or 11, wherein the second processing module is specifically configured to: determine, taking the information bit quantity k as 1 to M and based on the second subchannel number read when the information bit quantity is k and k-1, that a sequence of the newly added second subchannel number is a $k^{th}$ bit, and repeat the foregoing steps to obtain the extended sequence.

13. A polar encoding apparatus, comprising: a processor, wherein the processor is coupled to a memory, and is configured to invoke a computer program from the memory and run the computer program, to perform the method according to any one of claims 1 to 3 or the method according to any one of claims 7 to 9.

14. A computer-readable storage medium, wherein the computer-readable medium stores a computer program executed by a device, and the computer program comprises program instructions used to perform the method according to any one of claims 1 to 3 or program instructions used to perform the method according to any one of claims 7 to 9.

15. A chip, wherein the chip comprises a logic circuit and an input/output interface, wherein the input/output interface is configured to receive code instructions or information, and the logic circuit is configured to execute the code instructions or based on the information, to perform the method according to any one of claims 1 to 3, or the method according to any one of claims 7 to 9.

16. A computer program product, wherein the computer program product comprises a computer program, and when the computer program is run on a computer device, the computer device is enabled to perform the method according to any one of claims 1 to 3 or the method according to any one of claims 7 to 9.

17. A polar encoding apparatus, configured to implement the method according to any one of claims 1 to 3 or the method according to any one of claims 7 to 9.

18. A program, wherein when the program is run on a computer, the computer is enabled to perform the method according to any one of claims 1 to 3 or the method according to any one of claims 7 to 9.

Terminal device

Base station

Terminal device

FIG. 1

| Signal source | → | Source coding | → | Channel encoding | → | Modulation |

| Information sink | ← | Information source recovery | ← | Channel decoding | ← | Demodulation |

FIG. 2

FIG. 3

FIG. 4

500

| Obtain a second sequence L2 based on a first sequence L1 | ⟿ S510 |

| Determine a subchannel number of a third sequence from a subchannel number of the first sequence based on a subchannel number of the second sequence L2 | ⟿ S520 |

| Perform encoding based on the third sequence | ⟿ S530 |

FIG. 5

<u>600</u>

| Obtain X sequences based on a basic sequence | $\sim$ S610 |

| Read $K_1$ first subchannel numbers from a first sequence from back to front based on an information bit length K | $\sim$ S620 |

| Determine, based on the first subchannel numbers read from the basic sequence, that a quantity of subchannel numbers that is greater than $(j*N)/2^n$ and less than or equal to $(j+1)*N/2^n$ is $m_j$ | $\sim$ S630 |

| Read $m_j$ second subchannel numbers from a $(j+1)^{th}$ sequence | $\sim$ S640 |

| Determine an extended sequence based on the read second subchannel numbers | $\sim$ S650 |

| Perform encoding based on the extended sequence | $\sim$ S660 |

FIG. 6

700

| Obtain a third sequence | S710 |

| Perform encoding based on the third sequence | S720 |

FIG. 7

Apparatus 800

Obtaining module 801

Processing module 802

FIG. 8

Apparatus 900

Second obtaining module 901

Second processing module 902

FIG. 9

Apparatus 1000

Third obtaining module 1001

Third processing module 1002

FIG. 10

1100

1101

Processor

Instructions

1103

1102

Memory

Program

1104

Transceiver unit

1105

Antenna

1106

FIG. 11

1230

Memory

1220

Logic circuit

Chip

Input/Output interface

1210

FIG. 12

## INTERNATIONAL SEARCH REPORT

| International application No. |
| --- |
| **PCT/CN2021/104467** |

**A.    CLASSIFICATION OF SUBJECT MATTER**

H04L 1/00(2006.01)i;  H03M 13/13(2006.01)n

According to International Patent Classification (IPC) or to both national classification and IPC

**B.    FIELDS SEARCHED**

Minimum documentation searched (classification system followed by classification symbols)

H04L; H03M

Documentation searched other than minimum documentation to the extent that such documents are included in the fields searched

Electronic data base consulted during the international search (name of data base and, where practicable, search terms used)

CNABS, CNTXT, VEN, USTXT, EPTXT, WOTXT, CNKI, IEEE, 3GPP: polar码, 极化码, 极性码, 序列, 扩展, 延伸, 母码, 构造, 编码, 长度, polar code, sequence, extend+, mother code, construct+, design+, cod+, length.

**C.    DOCUMENTS CONSIDERED TO BE RELEVANT**

| Category* | Citation of document, with indication, where appropriate, of the relevant passages | Relevant to claim No. |
| --- | --- | --- |
| A | CN 108599891 A (HUAWEI TECHNOLOGIES CO., LTD.) 28 September 2018 (2018-09-28) description, paragraphs 74-79, 101-197, figures 3-7 | 1-18 |
| A | CN 108809333 A (HUAWEI TECHNOLOGIES CO., LTD.) 13 November 2018 (2018-11-13) entire document | 1-18 |
| A | CN 108667464 A (HUAWEI TECHNOLOGIES CO., LTD.) 16 October 2018 (2018-10-16) entire document | 1-18 |
| A | CN 110365445 A (ZTE CORPORATION) 22 October 2019 (2019-10-22) entire document | 1-18 |
| A | QUALCOMM INC. "Sequence Construction of Polar Codes for Control Channel" *3GPP TSG-RAN WG1 #90 R1-1713468*, 12 August 2017 (2017-08-12), entire document | 1-18 |
| A | HUAWEI et al. "Polar Code Construction for NR" *3GPP TSG RAN WG1 Meeting #86bis R1-1608862*, 01 October 2016 (2016-10-01), entire document | 1-18 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **11 August 2021** | **16 September 2021** |

| Name and mailing address of the ISA/CN | Authorized officer |
| --- | --- |
| **China National Intellectual Property Administration (ISA/ CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2021/104467**

| Patent document cited in search report | | | Publication date (day/month/year) | Patent family member(s) | | | Publication date (day/month/year) |
|---|---|---|---|---|---|---|---|
| CN | 108599891 | A | 28 September 2018 | EP | 3570472 | A4 | 22 January 2020 |
| | | | | US | 10979076 | B2 | 13 April 2021 |
| | | | | WO | 2018166455 | A1 | 20 September 2018 |
| | | | | EP | 3570472 | A1 | 20 November 2019 |
| | | | | CN | 108599891 | B | 08 May 2020 |
| | | | | US | 2020014403 | A1 | 09 January 2020 |
| | | | | IN | 201937031878 | A | 11 October 2019 |
| CN | 108809333 | A | 13 November 2018 | US | 2020059246 | A1 | 20 February 2020 |
| | | | | EP | 3598649 | A4 | 22 July 2020 |
| | | | | EP | 3598649 | A1 | 22 January 2020 |
| | | | | WO | 2018202195 | A1 | 08 November 2018 |
| | | | | IN | 201937034512 | | 22 November 2019 |
| CN | 108667464 | A | 16 October 2018 | BR | 112019020118 | A2 | 05 May 2020 |
| | | | | CN | 109347488 | B | 01 November 2019 |
| | | | | WO | 2018177386 | A1 | 04 October 2018 |
| | | | | US | 10673466 | B2 | 02 June 2020 |
| | | | | US | 2019379406 | A1 | 12 December 2019 |
| | | | | JP | 2020516111 | A | 28 May 2020 |
| | | | | AU | 2018243118 | A1 | 05 September 2019 |
| | | | | CN | 109347488 | A | 15 February 2019 |
| | | | | KR | 20190112130 | A | 02 October 2019 |
| | | | | EP | 3584936 | A1 | 25 December 2019 |
| | | | | US | 2020321984 | A1 | 08 October 2020 |
| | | | | CA | 3053264 | A1 | 04 October 2018 |
| | | | | AU | 2018243118 | B2 | 21 January 2021 |
| | | | | KR | 102221430 | B1 | 26 February 2021 |
| | | | | EP | 3584936 | A4 | 01 April 2020 |
| | | | | VN | 67974 | A | 30 January 2020 |
| | | | | IN | 201917032515 | A | 04 October 2019 |
| CN | 110365445 | A | 22 October 2019 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202011277626